# EUROPÄISCHE PATENTSCHRIFT

(11) **EP 0 783 596 B1**
(45) Veröffentlichungstag und Bekanntmachung des Hinweises auf die Patenterteilung: **05.04.2000**
(21) Anmeldenummer: 95929000.8
(22) Anmeldetag: 26.08.1995
(51) Int. Cl.: C23C 16/02, C23C 16/26, C23C 14/06, C23C 28/00

(54) **VERBUNDKÖRPER, VERWENDUNG DIESES VERBUNDKÖRPERS UND VERFAHREN ZU SEINER HERSTELLUNG**
COMPOSITE BODY, USE OF THIS COMPOSITE BODY AND PROCESS FOR ITS PREPARATION
CORPS COMPOSITE, SON UTILISATION ET SON PROCEDE DE FABRICATION

(30) Priorität: 27.09.1994 DE 4434428
(43) Veröffentlichungstag der Anmeldung: 16.07.1997
(73) Patentinhaber: Widia GmbH, 45145 Essen (DE)
(72) Erfinder: BUCK, Volker, D-42555 Velbert (DE); DEUERLER, Friederike, D-58640 Iserlohn (DE); TABERSKY, Ralf, D-46240 Bottrop (DE)
(74) Vertreter: Vomberg, Friedhelm, Dipl.-Phys.
(86) Internationale Anmeldenummer: DE9501158
(87) Internationale Veröffentlichungsnummer: WO9610102

(56) Entgegenhaltungen:
- EP-A- 0 200 088
- EP-A- 0 352 545
- EP-A- 0 607 987
- WO-A-92/17623
- WO-A-94/12680
- DATABASE WPI Section Ch, Week 9245 Derwent Publications Ltd., London, GB; Class L02, AN 92-368535 & JP,A,04 268 076 ( MITSUBISHI MATERIALS CORP) , 24.September 1992
- DIAMOND AND RELATED MATERIALS, Bd. 2, Nr. 5/7, 13.April 1993 AMSTERDAM NL, Seiten 890-892, DEMICHELIS ET AL. 'Mechanical and thermophysicla properties of diamond-like carbon (DLC) films with different sp3/sp2 ratios'
- APPLIED PHYSICS LETTERS, Bd. 63, Nr. 13, 27.September 1993 Seiten 1771-1773, XP 000397789 JACOB W ET AL 'ON THE STRUCTURE OF THIN HYDROCARBON FILMS'

## Beschreibung

Die Erfindung betrifft einen Verbundkörper, bestehend aus einem Hartmetall-, Cermet-, Keramik- oder Stahlgrundkörper, auf dem mindestens eine Zwischenschicht und eine äußere polykristalline Diamantschicht einer Gesamtdicke zwischen 0,5 µm und 25 µm aufgetragen ist.

Bei der Beschichtung der obengenannten Grundkörper mit einer Diamantschicht, insbesondere zur Schaffung eines harten Werkzeuges mit hoher Beständigkeit gegen Abrasivverschleiß sind mehrere Bedingungen zu erfüllen. Da eine direkte Abscheidung von Diamantschichten durch ein CVD-Verfahren aus gasförmigen Wasserstoff-Kohlenwasserstoff-Gemischen auf Eisen-, Kobalt- oder Nickel-haltigen Stoffen nicht nur hinsichtlich einer unzureichenden Keimbildung schwierig ist, sondern wegen der Gehalte an Metallen der Eisengruppe auch unerwünschte Graphitabscheidungen begünstigt, wurde schon früh vorgeschlagen, die oberflächennahen Schichten des Grundkörpers mechanisch und/oder chemisch zu präparieren, um die Haftung der Diamantschicht zu verbessern und eine Diffusionssperre für Elemente der Eisengruppe zu errichten. Dies konnte entweder durch Fe-, Co- oder Ni-Verarmung der Randschichten oder durch diffusionshemmende Zwischenschichten geschehen. Diese Zwischenschichten müssen so beschaffen sein, daß insbesondere unter thermischer oder mechanischer Belastung Spannungen an den Grenzflächen zum Substratkörper sowie der Diamantschicht möglichst kompensiert, zumindest aber möglichst gering gehalten werden. Diese Forderungen konnten in der Vergangenheit zum Teil nur unzureichend erfüllt werden.

So ist in der EP 0 435 272 A1 zur Beschichtung eines keramischen Körpers auf Siliziumnitridbasis vorgeschlagen worden, den gesinterten Keramikkörper einer Kristallisationsbehandlung bei einer Temperatur zwischen 1400°C und 1700°C eine halbe bis 10 Stunden zu unterziehen, bevor die Diamantschicht mittels CVD aufgetragen wird.

Nach der EP 0 500 119 A1 soll in oberflächennahen Schichten eine Kobaltverarmung des im übrigen 4 bis 20 Gew.-% enthaltenden WC-Co-Hartmetallgrundkörpers herbeigeführt werden. Hierzu wird der Grundkörper zwei Sinterverfahren unterworfen, wovon das zweite unter einer Inert-Druckgasatmosphäre stattfinden soll, bevor die Oberfläche chemisch geätzt und anschließend ultraschallbehandelt wird.

Nach der EP 0 384 011 A1 wird als Substratkörper, auf den die Diamantschicht aufgetragen wird, eine hauptsächlich aus W₂C und WC bestehende Zusammensetzung vorgeschlagen.

Temperatur- und Druckbehandlungen nach dem Sintern, denen ein Substratkörper vor der Diamantbeschichtung unterzogen werden soll, werden in unterschiedlicher Weise auch in der EP 0 374 923 A2, EP 0 403 986 A1 und EP 0 480 895 A2 vorgeschlagen.

Als Material für Zwischenschichten sind nach dem Stand der Technik bekannt: Eine SiC-Barriereschicht (DE 42 35 015 A1), eine Schicht aus einem Carbid-bildenden Metall, wie W, Mo, Ta, Si, Pt oder Legierungen hieraus (EP 0 534 729 A2), Lotschichten aus Metallen der IVa- bis VIIa-Gruppe des Periodensystemes, Carbiden hieraus oder Au, Ag, Cu, Pt, Pd, Ni, ggf. auch als Doppelschicht unterhalb der äußeren Diamantschicht (EP 0 541 071 A1), TiN auf einer Trägerkörperoberfläche mit nicht ebener Geometrie (EP 0 297 072 B1), Siliziumnitrid (EP 0 385 283 B1) oder CrCₓ (EP 0 589 641).

Bei jeder der vorgeschlagenen Lösungen war entweder eine unzureichende Haftung der Oberflächenschichten auf dem Substratkörper, eine unzureichende mechanische oder thermische Belastungsfähigkeit, im wesentlichen hervorgerufen durch innere Spannungen aufgrund unterschiedlicher thermischer Ausdehnungskoeffizienten etc., oder eine schlechte Diamantkeimbildung beim abschließenden Auftrag der äußeren Schicht festzustellen.

Die JP-A-4268076 betrifft einen Keramikgrundkörper, der mit einer Zwischenschicht aus amorphem Kohlenstoff und einer äußeren polykristallinen Diamantschicht versehen ist. Die Zwischenschicht aus amorphem Kohlenstoff enthält 1 bis 30 Atom-% Fluor und 1 bis 30 Atom-% Wasserstoff.

Es ist Aufgabe der vorliegenden Erfindung, einen ähnlichen Verbundkörper anzugeben, wobei die Zwischenschicht zwischen dem Substratkörper und der äußeren Diamantschicht eine ausreichende Blockierung von Graphitabscheidungen begünstigenden Metallen aus dem Substratkörper gewährleistet, die für eine ausreichende Haftung der aufgetragenen Schichten auf dem Substratkörper sorgt und bei der die entstehenden Spannungen sowohl bei thermischen wie auch mechanischen Belastungen möglichst gering sind. Schließlich soll die Zwischenschicht eine gute wie möglichst rasche Abscheidung von einer polykristallinen Diamantschicht ermöglichen.

Weiterhin ist es Aufgabe der Erfindung, eine Verwendung des zu schaffenden Verbundwerkstoffes und ein Verfahren zu seiner Herstellung anzugeben.

Diese Aufgabe wird durch den Verbundkörper nach Anspruch 1 dadurch gelöst, daß mindestens eine der Zwischenschichten im wesentlichen aus amorphem Kohlenstoff besteht, der mindestens 20 Atom-% sp³-Hybridorbitale enthält, ausgenommen fluorhaltige Zwischenschichten.

Die erfindungsgemäße Lösung schließt eine einlagige Zwischenschicht zwischen dem Substratkörper und der äußeren polykristallinen Diamantschicht ebenso ein wie mehrlagige Zwischenschichten, wovon mindestens eine, vorzugsweise die unterhalb der äußeren polykristallinen Diamantschicht liegende Zwischenschicht aus amorphem Kohlenstoff besteht, der mindestens 20 Atom-% sp³-Hybridorbitale enthält, ausgenommen fluorhaltige Zwischenschichten.

Die Abscheidung von amorphem, überwiegend tetraedrisch gebundenem Kohlenstoff ist prinzipiell, allerdings auf anderen Substratkörpern, wie Silizium-Grundkörpern oder Silizium-haltigen Grundkörpern, wie Quarz oder Glas, bekannt. Überraschenderweise hat sich jedoch gezeigt, daß auch bei Abscheidungen auf anderen Stoffen als dem chemisch mit dem Kohlenstoff verwandten Silizium eine hervorragende Haftung bei geringen mechanischen Spannungen an den Grenzflächen und den Oberflächenschichten erzielbar sind. Amorpher, überwiegend tetraedrisch gebundener Kohlenstoff kann durch Verdampfung von Graphit oder über ein Kohlenwasserstoffgas erzeugt werden. Amorpher Kohlenstoff kann sowohl als reiner Kohlenstoff in tetraedrischer Form als auch unter Wasserstoff-, Stickstoff- oder Metalloid-Einbindungen in tetraedrischer Struktur auftreten. Amorphe Kohlenstoffschichten besitzen Dichten um 2,7 bis 2,9 g/cm³. Diese Zwischenschicht liefert bei einer nachfolgenden Beschichtung mit einem polykristallinen Diamant eine ausgezeichnete Keimbildung, welche zu einer dichten, haftungsfesten Diamantoberflächenbeschichtung führt. In der Praxis sind amorphe, überwiegend tetraedrisch gebundene Kohlenstoffschichten beispielsweise durch Abschmelzen eines reinen Kohlenstoffsubstrates mittels eines Nd-YAG-Lasers im Ultrahochvakuum erzeugbar.

Weiterbildungen des Verbundkörpers sind in den Ansprüchen 2 bis 7 beschrieben.

So enthält der amorphe Kohlenstoff vorzugsweise mindestens 50 Atom-% sp³-Hybridorbitale. Wie bereits erwähnt, kann in der amorphen Kohlenstoffschicht, jeweils tetraedrisch gebunden, Wasserstoff, Stickstoff und/oder Metalloid bis zu einem maximalen Anteil von 30 Atom-% enthalten sein. Vorzugsweise besteht die amorphe Kohlenstoffschicht ausschließlich aus Kohlenstoff mit einem sp³-Hybridorbitalanteil zwischen 20 Atom-% und 100 Atom-%, vorzugsweise >90 Atom-%, oder sie enthält bei einem sp³-Hybridorbitalanteil größer als 40 Atom-%, vorzugsweise >50 Atom-%, einen Wasserstoffgehalt von bis 30 Atom-%, Rest jeweils C-Atome mit sp²-Hybridorbital.

Nach einer weiteren Ausgestaltung der Erfindung besteht die erste, am Grundkörper anliegende Schicht oder eine weitere Zwischenschicht aus einem keramischen Material, vorzugsweise α-Al₂O₃.

Bevorzugt werden wegen der verbesserten Haftfähigkeit und optimalen Verschleißeigenschaften α-Al₂O₃-Schichten mit einer feinkristallinen Struktur, deren durch die Halbwertsbreiten der mit CuK_{α}-Röntgenstrahlung gemessenen Beugungslinien eine mindestens 3mal so große Halbwertsbreite als die eines pulverförmigen Kompaktkörpers aus α-Al₂O₃ oder einer mit einem CVD-Verfahren bei 1000°C bis 1100°C aufgetragenen α-Al₂O₃-schicht aufweisen. Solche α-Al₂O₃-Schichten werden in der WO 92/17623 beschrieben. Eine weitere Ausführungsvariante ist dadurch gekennzeichnet, daß die erste, am Grundkörper anliegende Schicht oder eine weitere Zwischenschicht aus feinkristallinem γ-Al₂O₃ und/oder α-Al₂O₃ mit einer Korngröße ≤50 nm oder aus diesen Modifikationen mit Anteilen von amorphem Al₂O₃ besteht, das mittels eines Plasma-CVD-Verfahrens bei Substrattemperaturen von 400°C bis 750°C, vorzugsweise 450° bis 550°C, mit einer an dem als Kathode geschalteten Substratkörper mit einer gepulsten Gleichspannung herbeigeführten Plasmaaktivierung aufgetragen worden ist. Diese Beschichtung wird in der WO 93/20257 im näheren erläutert. Alternativ hierzu oder zusätzlich kann die erste am Grundkörper anliegende Schicht oder eine weitere Zwischenschicht aus einem oder mehreren der Metalle Molybdän, Wolfram, Titan, Zirkon, Hafnium, Niob und/oder Tantal bestehen, beispielsweise mit einer Dicke von 0,1 bis 2 µm, wie sie als Zwischenschicht unterhalb einer metallfreien Hartstoffschicht, z.B. aus TiN, in der EP 0 200 088 B1 beschrieben wird.

Schließlich sind nach einer weiteren Ausgestaltung der Erfindung auch eine oder mehrere Zwischenschichten aus ternären Systemen, wie Al-Ti-N oder Zr-Ti-N oder aus Metallen der IVa- bis VIa-Gruppe des Periodensystemes und mindestens einem (im ternären System eingebundenen) Metalloid verwendbar. Solche Kohlenstoff-freien Zwischenschichten können gegenüber etwa in dem Substratkörper enthaltenen Metallen der Eisengruppen eine wirksame Diffusionsbarriere bilden, so daß bereits Kombinationen jeweils dünner Zwischenschichten einen ausreichenden Schutz gegen Graphitabscheidungen während der abschließenden Diamantbeschichtung liefern.

Vorzugsweise liegt die Gesamtdicke der Zwischenschicht oder der mehrlagigen Zwischenschicht zwischen 1 nm bis 10 µm, weiterhin vorzugsweise zwischen 0,1 µm bis 2 µm. Die Dicke der äußeren polykristallinen Diamantschicht liegt vorzugsweise zwischen 1 µm und 10 µm.

Der erfindungsgemäße Verbundkörper eignet sich nach einer weiteren Ausbildung der Erfindung gemäß Anspruch 8 zur Zerspanung von Aluminium-, Aluminium-Silizium-Legierungen, Aluminium-Matrix-Verbundwerkstoffe, aber auch zur Holz- oder Kunststoffbearbeitung. Der Verbundkörper besitzt durch die äußere Diamantschicht eine hohe Härte bei einem geringen Abrasivverschleiß.

Verfahrenstechnisch wird gemäß Anspruch 9 die der Erfindung zugrundeliegende Aufgabe dadurch gelöst, daß auf einen Hartmetall-, Cermet-, Keramik- oder Stahlgrundkörper eine erste Zwischenschicht aus Keramick, vorzugsweise α-Al₂O₃, bei Substrattemperaturen von 400°C bis 750°C mittels eines Plasma-CVD-Verfahrens aufgetragen wird, wobei die Plasmaaktivierung an dem als Kathode geschalteten Substratkörper mit einer gepulsten Gleichspannung herbeigeführt wird, oder eine erste aus feinkristallinen γ-Al₂O₃ und/oder α-Al₂O₃ mit einer Korngröße ≤50 nm oder aus diesen Modifikationen mit Anteilen von amorphem Al₂O₃ bestehende Zwischenschicht mittels eines Plasma-CVD-Verfahrens bei Substrattemperaturen von 400°C bis 750°C, vorzugsweise 450°C bis 550°C, mit einer gepulsten Gleichspannung herbeigeführten Plasmaaktivierung auf dem als Kathode geschalteten Substratkörper aufgetragen wird oder eine erste Zwischenschicht aus einem oder mehreren der Metalle Molybdän, Wolfram, Titan, Zirkon, Hafnium, Niob und/oder Tantal durch einen PVD-Prozeß bei Substratkörpertemperaturen zwischen 200°C und 600°, vorzugsweise durch Kathodenzerstäubung, oder eine erste Zwischenschicht aus Al-Ti-N, Zr-Ti-N oder aus Metallen der IVa- bis VIa-Gruppe des Periodensystemes mit mindestens einem Metalloid mittels PVD oder CVD aufgetragen wird, anschließend mindestens eine Schicht aus amorphem Kohlenstoff, der mindestens 20 Atom-% reinen Kohlenstoff in tetraedrischer Form (sp³-Hybridorbitalen) enthält, durch Verdampfung von Graphit, vorzugsweise im Lichtbogen oder in einem HF-C₂H₂⁺-Plasma und schließlich eine äußere Diamantschicht mittels eines Gleichstrom-Plasma-Jet-CVD-Verfahrens aufgetragen wird.

Nach einer weiteren Ausgestaltung können die Zwischenschichten aus keramischem Material, insbesondere α-Al₂O₃, den genannten Metallen oder den genannten ternären oder auch quaternären Stoffsystemen und die amorphe Kohlenstoffschicht mit tetraedrischer Struktur alternierend in ihrer Zusammensetzung aufgetragen werden, bevor abschließend die Diamantbeschichtung aufgetragen wird.

Die Verfahrenstechnik zur Abscheidung keramischer Schichten wird am Beispiel des α-Al₂O₃ in der WO 92/17623 und zur Abscheidung des Wolframs oder Molybdäns in der EP 0 200 088 B1 beschrieben. Die Abscheidung ternärer Hartstoffsysteme, z.B. des Al-Ti-N, als eine zusätzlich zur amorphen Kohlenstoffschicht abzuscheidenden Zwischenschicht wird beispielsweise in der EP 0 352 545 A2 offenbart.

Nach bevorzugten Ausführungsbeispielen wird auf einen Substratkörper eine einzige, maximal 2 µm dicke Zwischenschicht aus amorphem Kohlenstoff, der auch geringe Anteile an Wasserstoff enthalten kann, unterhalb der äußeren Diamantschicht abgeschieden.

Alternativ hierzu haben sich Verbundwerkstoffe bewährt, bei denen die am Substratkörper anliegende innere Zwischenschicht aus Wolfram oder Molybdän oder α-Al₂O₃ bestand, worauf der amorphe Kohlenstoff und schließlich die Diamantschicht abgeschieden wurden.

### Ausführungsbeispiele

| Ausführung | Verfahren | Beschichtungstemperatur | Schichtstoff | Schichtdicke |
|---|---|---|---|---|
| 1 | PVD (Arc Verfahren) | 650°C | a-C + | 1-2 µm |
| | DC Plasma Jet CVD | 750°C | Diamant | 8 µm |
| 2 | PCVD | 600°C | α-Al₂O₃ | 1-2 µm |
| | PVD | 650°C | a-C | 1 µm |
| | DC Plasma Jet CVD | 730°C | Diamant | 7 µm |

Bei der erfindungsgemäßen Ausführung nach Beispiel 1 ist auf einen Hartmetallgrundkörper (WC-6 % Co), der im Ultraschallbad gereinigt worden ist, eine Zwischenschicht mit einer Dicke von 1 bis 2 µm abgeschieden worden, die aus die Keimbildung unterstützendem amorphen Kohlenstoff bestand, der mittels eines PVD-Verfahrens (Arc-Ionen-Plattierungsprozeß) aufgetragen worden war. Die Diamantschicht mit einer Dicke von 8 µm ist mit einem Gleichstrom-Plasma-Jet CVD-Verfahren bei 750°C und 300 mbar hergestellt worden, wobei die hartstoffbildende reaktive Gasatmosphäre aus Methan und Wasserstoff durch eine Lichtbogenentladung teilweise ionisiert war (Plasmaaktivierung). Das Ergebnis stellte sich als eine gut haftende, 8 µm dicke Diamantschicht auf dem Substratkörper - hier in Form einer Wendeschneidplatte - dar, dessen REM-Untersuchung zeigte, daß in der äußeren Schicht eine feine, polykristalline Diamantstruktur vorliegt.

Im zweiten Ausführungsbeispiel werden Wendeschneidplatten aus Hartmetall und Werkzeugstähle (Schnellarbeitsstahl 1.3343) zunächst zur Verbesserung der Haftung der amorphen Kohlenstoffschicht mit einer ersten Zwischenschicht aus α-Al₂O₃ von 1 bis 2 µm Dicke beschichtet. Die α-Al₂O₃-Zwischenschicht wird durch ein Plasma-CVD-Verfahren auf dem Grundkörper abgeschieden, das in der WO 92/17623 beschrieben wird. Hiernach ist eine 1 µm dicke amorphe Kohlenstoffschicht auf das α-Al₂O₃ aufgetragen worden und abschließend eine 7 µm dicke polykristalline Diamantschicht. Bei den letzten beiden Schichten bediente man sich der Verfahren, die bereits zuvor erwähnt sind.

## Patentansprüche

1. Verbundkörper, bestehend aus einem Hartmetall-, Cermet-, Keramik- oder Stahlgrundkörper, auf dem mindestens eine Zwischenschicht und eine äußere polykristalline Diamantschicht einer Dicke zwischen 0,5 um und 25 µm aufgetragen ist,
**dadurch gekennzeichnet,**
daß mindestens eine der Zwischenschichten im wesentlichen aus amorphem Kohlenstoff besteht, der mindestens 20 Atom-% sp³-Hybridorbitale enthält, ausgenommen fluorhaltige Zwischenschichten.

2. Verbundkörper nach Anspruch 1, dadurch gekennzeichnet, daß der amorphe Kohlenstoff mindestens 50 Atom-% reinen Kohlenstoff in tetraedrischer Form (sp³-Hybridorbitalen) enthält.

3. Verbundkörper nach einem der Ansprüche 1 oder 2, dadurch gekennzeichnet, daß die amorphe Kohlenstoffschicht ausschließlich Kohlenstoff mit einem sp³-Hybridorbitalanteil zwischen 20 Atom-% und 100 Atom-%, vorzugsweise >90 Atom-%, enthält oder bei einem sp³-Hybridorbitalanteil von >40 Atom-%, vorzugsweise >50 Atom-%, einen Wasserstoffgehalt bis ≤30 Atom-%, Rest jeweils C-Atome mit sp²-Hybridorbital enthält.

4. Verbundkörper nach einem der Ansprüche 1 bis 3, dadurch gekennzeichnet, daß die erste, am Grundkörper anliegende Schicht oder eine weitere Zwischenschicht aus keramischem Material, vorzugsweise α-Al₂O₃, besteht.

5. Verbundkörper nach einem der Ansprüche 1 bis 4, dadurch gekennzeichnet, daß die α-Al₂O₃-schicht eine feinkristalline Struktur aufweist, deren durch die Halbwertsbreiten der mit CuK_{α}-Röntgenstrahlung gemessenen Beugungslinien eine mindestens 3mal so große Halbwertsbreite als die eines pulverförmigen Kompaktkörpers aus α-Al₂O₃ oder einer mit einem CVD-Verfahren bei 1000°C bis 1100°C aufgetragenen α-Al₂O₃-Schicht aufweisen oder daß die erste, am Grundkörper anliegende Schicht oder eine weitere Zwischenschicht aus feinkristallinem γ-Al₂O₃ und/oder α -Al₂O₃ mit einer Korngröße ≤50 nm oder aus diesen Modifikationen mit Anteilen von amorphem Al₂O₃ besteht, das mittels eines Plasma-CVD-Verfahrens bei Substrattemperaturen von 400°C bis 750°C, vorzugsweise 450° bis 550°C, mit einer an dem als Kathode geschalteten Substratkörper mit einer gepulsten Gleichspannung herbeigeführten Plasmaaktivierung aufgetragen worden ist.

6. Verbundkörper nach einem der Ansprüche 1 bis 5, dadurch gekennzeichnet, daß die erste am Grundkörper anliegende Schicht oder eine weitere Zwischenschicht aus einem oder mehreren der Metalle Molybdän, Wolfram, Titan, Zirkon, Hafnium, Niob und/oder Tantal besteht und/oder eine der Zwischenschichten aus Al-Ti-N oder Zr-Ti-N oder aus Metallen der IVa- bis VIa-Gruppe des Periodensystemes und mindestens einem Metalloid besteht.

7. Verbundkörper nach einem der Ansprüche 1 bis 6, dadurch gekennzeichnet, daß die Gesamtdicke der Zwischenschicht oder mehrlagigen Zwischenschicht zwischen 1 nm bis 10 µm, vorzugsweise 0,1 µm bis 2 µm beträgt und/oder die Dicke der äußeren polykristallinen Diamantschicht zwischen 1 µm und 10 µm liegt.

8. Verwendung eines Verbundkörpers nach einem der Ansprüche 1 bis 7 zur Aluminium-Silizium-Legierung-, Aluminium-Matrix-Verbundwerkstoff-, Holz- oder Kunststoffzerspanung.

9. Verfahren zur Herstellung eines Verbundkörpers nach einem der Ansprüche 1 bis 8, dadurch gekennzeichnet, daß auf einem Hartmetall-Cermet-, Keramik- oder Stahlgrundkörper eine erste Zwischenschicht aus Keramik, vorzugsweise α-Al₂O₃ bei Substrattemperaturen von 400°C bis 750°C mittels eines Plasma-CVD-Verfahrens aufgetragen wird, wobei die Plasmaaktivierung an dem als Kathode geschalteten Substratkörper mit einer gepulsten Gleichspannung herbeigeführt wird, oder eine erste aus feinkristallinen γ-Al₂O₃ und/oder α-Al₂O₃ mit einer Korngröße ≤50 nm oder aus diesen Modifikationen mit Anteilen von amorphem Al₂O₃ bestehende Zwischenschicht mittels eines Plasma-CVD-Verfahrens bei Substrattemperaturen von 400°C bis 750°C, vorzugsweise 450°C bis 550°C, mit einer gepulsten Gleichspannung herbeigeführten Plasmaaktivierung auf dem als Kathode geschalteten Substratkörper aufgetragen wird, oder eine erste Zwischenschicht aus einem oder mehreren der Metalle Molybdän, Wolfram, Titan, Zirkon, Hafnium, Niob und/oder Tantal durch einen PVD-Prozeß bei Substratkörpertemperaturen zwischen 200°C und 600°C, vorzugsweise durch Kathodenzerstäubung, oder eine erste Zwischenschicht aus Al-Ti-N, Zr-Ti-N oder aus Metallen der IVa- bis VIa-Gruppe des Periodensystemes mit mindestens einem Metalloid mittels PVD oder CVD aufgetragen wird, anschließend mindestens eine Schicht aus amorphem Kohlenstoff, der mindestens 20 Atom-% reinen Kohlenstoff in tetraedrischer Form (sp³-Hybridorbitalen) enthält, durch Verdampfung von Graphit, vorzugsweise im Lichtbogen oder in einem HF-C₂H₂⁺-Plasma, und schließlich eine äußere Diamantschicht mittels eines Gleichstromplasma-Jet-CVD-Verfahrens aufgetragen wird.

10. Verfahren nach Anspruch 9, dadurch gekennzeichnet, daß die Zwischenschichten als mehrlagige Schichten alternierend in ihrer Zusammensetzung aufgetragen werden.

## Claims

1. Composite body consisting of a hard metal, cermet, ceramic or steel base body on which at least one intermediate layer and an outer polycrystalline diamond layer is applied with a thickness between 0,5 µm and 25 µm,
**characterised in that**
at least one of the intermediate layers consists substantially of amorphous carbon containing at least 20 atom-% sp³-hybridized orbital, excluded are fluorine containing intermediate layers.

2. Composite body according to claim 1, characterised in that the amorphous carbon contains at least 50 atom-% pure carbon in tetrahedral modification (sp³-hybridized orbital).

3. Composite body, according to one of claims 1 or 2, characterised in that the amorphous carbon layer exclusively contains carbon with a sp³-hybridized orbital portion between 20 atom-% and 100 atom-%, preferably > 90 atom-%, or contains with a sp³-hybridized orbital portion of > 40 atom-%, preferably > 50 atom-% a hydrogen concentration of up to ≤ 30 atom-%, the rest contains C-atoms with sp²-hybridized orbital.

4. Composite body according to one of claims 1 to 3, characterised in that the first layer arranged at the base body or another intermediate layer consists of ceramic material, preferably α-Al₂O₃.

5. Composite body according to one of claims 1 to 4, characterised in that the α-Al₂O₃-layer has a fine crystalline structure whose diffraction lines measured by the half width of the CuK_{α}-X-ray-intensity have a half width being at least 3 times greater than the half width of a powdery compacted body of α-Al₂O₃ or than a layer of α-Al₂O₃, applied by a CVD-method at 1000°C to 1100°C, or that the first layer on the substrate body or a further intermediate layer of fine crystalline γ-Al₂O₃ and/or α-Al₂O₃ with a grain size ≤ 50 nm or of modifications thereof with portions of amorphous Al₂O₃, that layer being applied by a plasma PVD-method at substrate temperatures of 400°C to 750°C, preferably 450°C to 550°C, onto a substrate body serving as a cathode in a pulsed DC-voltage activated plasma.

6. Composite body according to one of the claims 1 to 5, characterised in that the first layer adjacent to the base body or a further intermediate layer consists of one or more metals molybdenum, tungsten, titanium, zirconium, hafnium, niobium, and/or tantalum and/or one of the intermediate layers consists of Al-Ti-N or Zr-Ti-N or of metals of the IVa- to VIa-group of the periodic table and at least one metalloid.

7. Composite body according to one of the claims 1 to 6, characterised in that the total thickness of the intermediate layer or intermediate layers is between 1 nm to 10 µm, preferably 0,1 µm to 2 µm and/or the thickness of the outer polycrystalline diamond layer is between 1 µm to 10 µm.

8. Use of the composite body according to one of the claims 1 to 7 for cutting aluminum-silicon-alloy-compound-materials, aluminum-matrix-compound-materials, wood or synthetic materials.

9. Process for manufacturing a composite body according to one of the claims 1 to 8, characterised in that onto a hard metal-, cermet-, ceramic- or steel base body a first intermediate layer of ceramic, preferably α-Al₂O₃ is applied at substrate temperatures of 400°C to 750°C by a plasma-CVD-process, thereby the plasma is activated with a pulsed direct current voltage the substrate body operating as cathode, or a first intermediate layer consisting of fine crystalline γ-Al₂O₃ and/or Al₂O₃ with a grain size ≤ 50 nm or of modifications thereof with parts of amorphous Al₂O₃ is applied by a plasma-CVD-process at substrate temperatures of 400°C to 750°C, preferably 450°C to 550°C, using the substrate body as cathode and a pulsed direct current voltage for the plasma activation, or a first intermediate layer of one or more of the metals molybdenum, tungsten, titanium, zirconium, hafnium, niobium, and/or tantalum is applied by a PVD-process at substrate body temperatures between 200°C to 600°C, preferably by cathode sputtering, or a first intermediate layer of Al-Ti-N, Zr-Ti-N or of metals of the IVa to Via group of the periodic table with at least one metalloid is applied by PVD or CVD, following at least one layer of amorphous carbon containing at least 20 atom-% pure carbon in tetrahedral modification (sp³-hybridized orbital) made by vaporisation of graphite, preferably in an arc or in a HF-C₂H₂⁺-Plasma, and finally applying an outer diamond layer by a direct current plasma-jet-CVD-process.

10. Process according to claim 9, characterised in that the intermediate layers are applied as multiple layers alternating in their composition.

## Revendications

1. Corps composite se composant d'un corps de base en métal dur, en cermet, en céramique ou en acier, sur lequel est appliquée du moins une couche intermédiaire et une couche extérieure de diamant polycristallin ayant une épaisseur comprise entre 0,5 µm et 25 µm,
**caractérisé par le fait**
que l'une du moins des couches intermédiaires se compose pour l'essentiel de carbone amorphe qui contient du moins 20 % atomique d'orbitales hybrides sp³, à l'exception de couches intermédiaires contentant du fluor.

2. Corps composite selon la revendication 1, caractérisé par le fait que le carbone amorphe contient du moins 50 % atomique de carbone pur en forme tétraédrique (orbitales hybrides sp³).

3. Corps composite selon l'une des revendications 1 ou 2, caractérisé par le fait que la couche en carbone amorphe contient exclusivement du carbone avec un pourcentage d'orbitales hybrides sp^{3,} qui est compris entre 20 % atomique et 100% atomique, de préférence > 90 % atomique, ou qu'elle contient, à un pourcentage d'orbitales hybrides sp³ de > 40 % atomique, de préférence > 50 % atomique, une teneur en hydrogène allant jusqu'à ≤30 % atomique, le reste présente respectivement des atomes C avec une orbitale hybride sp².

4. Corps composite selon l'une des revendications 1 à 3, caractérisé par le fait que la première couche appliquée sur le corps de base ou une autre couche intermédiaire se compose de matière céramique, de préférence de α-Al₂O₃.

5. Corps composite selon l'une des revendications 1 à 4, caractérisé par le fait que la couche en α-Al₂O₃ présente une structure à fins cristaux, dont les lignes de diffraction mesurées par les largeurs de valeur moyenne des lignes de diffraction mesurées avec un rayonnement X CuK_{α} présentent une largeur de valeur moyenne, qui est du moins 3 fois plus grande que celle d'un corps compact pulvérulent en α-Al₂O₃ ou d'une couche en α-Al₂O₃ appliquée au moyen d'un procédé CVD à des températures comprises entre 1000°C et 1100°C, ou que la première couche appliquée sur le corps de base ou une autre couche intermédiaire se compose de γ-Al₂O₃ et/ou α-Al₂O₃ à fins cristaux avec une grosseur de grain ≤ 50 nm, ou de ces modifications avec des fractions de Al₂O₃ amorphe, qui a été appliquée par l'intermédiaire d'un procédé CVD à plasma à des températures de substrat comprises entre 400°C et 750°C, de préférence entre 450°C et 550°C, avec une activation par plasma produite par une tension continue pulsée, le corps substrat étant connecté en tant que cathode.

6. Corps composite selon l'une des revendications 1 à 5, caractérisé par le fait que la première couche appliquée sur le corps de base ou une autre couche intermédiaire se compose d'un ou de plusieurs des métaux molybdène, tungstène, titane, zirconium, hafnium, niobium et/ou tantale, et/ou que l'une des couches intermédiaires se compose de Al-Ti-N ou de Zr-Ti-N ou de métaux du groupe IVa à VIa de la classification périodique des éléments et d'un métalloïde du moins.

7. Corps composite selon l'une des revendications 1 à 6, caractérisé par le fait que l'épaisseur totale de la couche intermédiaire ou couche intermédiaire à plusieurs couches est comprise entre 1 nm et 10 µm, de préférence entre 0,1 µm et 2 µm, et/ou que l'épaisseur de la couche extérieure en diamant polycristallin est comprise entre 1 µm et 10 µm.

8. Utilisation d'un corps composite selon l'une des revendications 1 à 7 pour l'usinage à enlèvement de copeaux d'alliages aluminium-silicium, de matériaux composites à matrice d'aluminium, de bois ou de matières synthétiques.

9. Procédé de fabrication d'un coprs composite selon l'une des revendications 1 à 8, caractérisé par le fait qu'une première couche intermédiaire en céramique, de préférence en α-Al₂O₃, est appliquée sur un corps de base en métal dur, en cermet, en céramique ou en acier, à des températures de substrat comprises entre 400°C et 750°C par le biais d'un procédé CVD à plasma dans le cas duquel l'activation par plasma est produite avec une tension continue pulsée, le corps substrat étant connecté en tant que cathode, ou qu'une première couche intermédiaire se composant de γ-Al₂O₃ et/ou α-Al₂O₃ à fins cristaux avec une grosseur de grain ≤ 50 nm ou de ces modifications avec des fractions de Al₂O₃ amorphe est appliquée au moyen d'un procédé CVD à plasma, à des températures de substrat comprises entre 400°C et 750°C, de préférence entre 450°C et 550°C, avec une activation par plasma produite avec une tension continue pulsée, le corps substrat étant connecté en tant que cathode, ou qu'une première couche intermédiaire se composant d'un ou de plusieurs des métaux molybdène, tungstène, titane, zirconium, hafnium, niobium et/ou tantale est appliquée par un processus PVD à des températures de corps de substrat comprises entre 200°C et 600°C, de préférence par pulvérisation cathodique, ou qu'une première couche intermédiaire se composant de Al-Ti-N, Zr-Ti-N ou de métaux du groupe IVa à VIa de la classification périodiques des éléments avec du moins un métalloïde est appliquée au moyen de PVD ou de CVD, ensuite, du moins une couche en carbone amorphe contenant du moins 20 % atomique de carbone pur en forme tétraédrique (orbitales hybrides sp³), par vaporisation de graphite, de préférence dans l'arc électrique ou dans un plasma HF C₂H₂⁺, et que, enfin, une couche extérieure de diamant est appliquée au moyen d'un procédé CVD à jet de plasma à courant continu.

10. Procédé selon la revendication 9, caractérisé par le fait que les couches intermédiaires sont appliquées en tant que couches à plusieurs couches,alternant dans leur composition.
